# EUROPÄISCHE PATENTSCHRIFT

(11) **EP 2 574 996 B1**
(45) Veröffentlichungstag und Bekanntmachung des Hinweises auf die Patenterteilung: **06.08.2014**
(21) Anmeldenummer: 11183290.3
(22) Anmeldetag: 29.09.2011
(51) Int. Cl.: G05B 17/02, G05B 19/418, G06F 17/50

(54) **Verfahren zur Ermittlung eines Teillastzustandes einer Anlage**
Method for determining a partial load state of a system
Procédé de détermination de l'état de la charge partielle d'un système

(43) Veröffentlichungstag der Anmeldung: 03.04.2013
(73) Patentinhaber: Siemens Aktiengesellschaft, 80333 München (DE)
(72) Erfinder: Hassel, Jörg, 91058 Erlangen (DE); Neidig, Jörg, 90403 Nürnberg (DE); Pirker, Michael, 81827 München (DE); Seitz, Christian, 80337 München (DE)

(56) Entgegenhaltungen:
- US-A1- 2002 143 497
- US-A1- 2003 050 817
- US-A1- 2003 159 123
- US-A1- 2010 087 963
- US-B1- 7 343 353

## Beschreibung

Die Erfindung betrifft ein Verfahren zur Ermittlung eines Teillastzustandes einer mehrere Komponenten umfassenden Anlage, ein Computerprogrammprodukt sowie eine Verwendung eines anlagenglobalen Teillastzustands.

Gegenwärtige Anlagen, insbesondere Produktions- und Fertigungsanlagen, werden derzeit üblicherweise mit voller Last betrieben oder sie werden komplett abgeschaltet. Bei einer lediglich teilweisen Auslastung der Anlage, etwa bestimmt durch Vorgaben einer Auftragslage, wäre es nicht zuletzt im Hinblick auf den Energieverbrauch der Anlage günstiger, die Anlage in einem Teillastbetrieb zu fahren.

Aus der Druckschrift US7343353B1 geht ein Verfahren zur Steuerung einer Anlagenkomponente hervor, bei der die Anlagenkomponente für eine definierte Zeit unter Volllast oder einem Ruhestand eingestellt wird, um die Anlage in einem bestimmten Teillastzustand und in einer möglichst energieeffizienten Weise zu betreiben. Ein Verhältnis zwischen Zuständen der Anlagenkomponente und einem Teillastzustand der Anlage wird gemäß einem Modell beschrieben.

Neben dem genannten Energievorteil sprechen auch andere Gegebenheiten, insbesondere Wartungsintervalle und Lebensdauer einzelner Komponenten, dafür, eine Anlage in einem Teillastzustand zu betreiben, statt diese eine bestimmte Zeit lang unter Volllast und danach im Ruhezustand zu betreiben.

Soll eine komplette Anlage in einem bestimmten Teillastzustand betrieben werden, müssen naturgemäß die einzelnen Komponenten dieser Anlage in einem jeweiligen Teillastzustand betrieben werden. Unter Komponenten sind beispielsweise Prozessierungsgeräte oder Roboter einer Fertigungslinie, ferner auch Einrichtungen wie Förderbänder und Motoren zu verstehen, welche häufig über eine zumindest minimale elektronische Steuerung sowie eine mehr oder weniger ausgeprägte Kommunikationsschnittstelle zum Austausch von Prozess- und Betriebsdaten verfügen.

Bei einem Betrieb einzelner Komponenten der Anlage in einem Teillastzustand ist indes zu beachten, dass einerseits bestimmte Komponenten nicht jeden beliebigen Teillastzustand erlauben und dass ferner mögliche bzw. erlaubte Teillastzustände einzelner Komponenten nicht die gleiche Wirkung auf die Anlage haben. Beispielsweise kann ein Motor mit 25% einer vorgesehenen Vollleistung betrieben werden, die darauffolgende Maschine jedoch nur mit 50%.

Ein weiteres Problem besteht darin, dass ein Betrieb aller Komponenten der Anlage in einem bestimmten Teillastzustand, beispielsweise 50% des vorgesehenen Volllastzustandes, für unterschiedliche Komponenten unterschiedliche Auswirkungen hat. So kann beispielsweise ein Teillastzustand von 50% auf eine erste Komponente eine andere Auswirkung auf deren Durchsatz haben als auf eine zweite Komponente. Das Verhältnis zwischen Teillastzuständen einer Komponente und Betriebsparametern wie dem voraus erwähnten Durchsatz ist derzeit weder für einzelnen Komponenten noch für eine gesamte Anlage definiert. Selbst wenn eine Definition für einzelne Komponenten vorläge, stünde ein Anlagenplaner vor dem Problem, eine Implementierung mindestens eines Teillastzustandes in einer kompletten Anlage zu realisieren, welches sich aufgrund der unterschiedlichen Verhaltensweisen einzelner Komponenten als äußerst komplexes Problem darstellt.

Aufgabe der Erfindung ist es, ein Verfahren zur Ermittlung eines Teillastzustandes einer mehreren Komponenten umfassenden Anlage anzugeben.

Eine Lösung der Aufgabe erfolgt hinsichtlich ihres Verfahrensaspekts durch ein Verfahren mit den Merkmalen des Patentanspruchs 1. Eine Lösung der Aufgabe erfolgt weiterhin durch ein Computerprogramm mit den Merkmalen des Patentanspruchs 11, durch eine Verwendung in einem Prozesssteuerungssystem mit den Merkmalen des Patentanspruchs 12 sowie durch eine Verwendung in einer Komponente mit den Merkmalen des Patentanspruchs 13.

Im erfindungsgemäßen Verfahren zur Ermittlung eines Teillastzustandes einer mehrere Komponenten umfassenden Anlage, sind dabei nachfolgende Schritte vorgesehen:
- Auswerten eines Energiemodells mindestens einer Komponente der Anlage, durch welches mindestes einem Teillastzustand dieser Komponente ein Satz von Betriebsparametern dieser Komponente zugeordnet ist;
- Auswerten von Vorgabeparameter, die Vorgabeparameter umfassend Vorgaben für einen einzustellenden Durchsatz der Anlage;
- Ermittlung eines Satzes von Teillastzuständen der Anlage auf Grundlage des mindestens einen Energiemodells unter Berücksichtigung der Vorgabeparameter;
- Simulation des Satzes von Teillastzuständen anhand eines parametrisierbaren Simulationsmodells der Anlage.

Die Reihenfolge der ersten beiden Verfahrensschritte ist im Übrigen beliebig, so dass die Auswertung des Energiemodells sowie die Auswertung der Vorgabeparameter auch in einer anderen als der beanspruchten Reihenfolge erfolgen kann.

Die Erfindung basiert auf mindestens einem Energiemodell, welches in idealer jedoch nicht notwendiger Weise für nahezu jede Komponente einer Anlage vorliegt.

Mit Anwendung des erfindungsgemäßen Verfahrens wird ein Anlagenplaner in die Lage versetzt, auf Vorgabe von Vorgabeparametern, beispielsweise einen Mindestdurchsatz der Anlage oder einen maximalen Energieverbrauch, einen Satz von Teillastzuständen also einen Teillastzustand für jeden der an der Ermittlung beteiligten Komponente zu erhalten. Auf diese Weise kann ein individueller Teillastzustand für jede Komponente eingestellt werden, wobei alle Teillastzustände die Maßgabe der Vorgabeparameter erfüllen.

Vorteilhafte Weiterbildungen der Erfindung sind Gegenstand der Unteransprüche.

In vorteilhafter Weise enthalten die Betriebsparameter des Energiemodells eine Zeitdauer, welche eine von einer Komponente benötigte Zeit für einen Wechsel in einen jeweiligen Teillastzustand der Komponente oder für einen Wechsel von einem jeweiligen Teillastzustand in einen anderen angibt.

Eine vorteilhafte Ausführungsform der Erfindung sieht vor, dass die Betriebsparameter des Energiemodells einen Energieverbrauch eines jeweiligen Teillastzustands der Komponente enthalten. Eine derartige Maßnahme gestattet eine Optimierung der gesamten Anlage hinsichtlich eines Teillastzustandes, bei dem die Komponenten unter Maßgabe eines gewünschten Durchsatzes in einem möglichst energieeffizienten Betrieb arbeiten.

Gemäß einer weiteren vorteilhaften Ausgestaltung der Erfindung enthalten die Betriebsparameter darüber hinaus einen Energieverbrauch, welche für einen Wechsel von oder für einen Wechsel in einen jeweiligen Teillastzustand der Komponente erforderlich ist. Zur Einstellung eines günstigen Energieverbrauchs der Anlage werden hier also auch dynamische Aspekte berücksichtigt, welche sich bei einem Teillastzustandswechsel der Anlage ergeben.

Eine weitere vorteilhafte Ausgestaltung der Erfindung sieht vor, dass die Betriebsparameter des Energiemodells Angaben zum Betrieb der Komponente in einem jeweiligen Teillastzustand enthalten. Unter den genannten Angaben zum Betrieb sind hier vornehmlich ein komponentenbezogener Durchsatz zu verstehen, mithin einer Angabe, dass bei einem 50%-igen Teillastbetrieb z.B. eines Motors ein gegenüber dem Volllastbetrieb 40%-iger Durchsatz zu erwarten ist. Diese Maßnahme trägt dem Umstand Rechnung, dass ein Teillastbetrieb nicht notwendigerweise linear mit einem zugehörigen Durchsatz der Komponente verläuft.

Gemäß einer weiteren vorteilhaften Ausgestaltung der Erfindung ist vorgesehen, dass die Betriebsparameter Werte enthalten, welche eine Auswirkung eines Teillastzustandes sowie eines Wechsels zwischen jeweiligen Teillastzuständen auf die Lebensdauer und auf ein erforderliches Wartungsintervall der Komponente enthalten. Diese Ausführungsform gewährleistet eine Berücksichtigung der Auswirkungen, welche Teillastzustandswechsel auf einen in Kauf zu nehmenden Anstieg von Wartungsintervallen bzw. auf die Lebensdauer einer einzelnen Komponente bzw. der gesamten Anlage haben kann.

Gemäß einer weiteren vorteilhaften Ausgestaltung des erfindungsgemäßen Verfahrens ist vorgesehen, dass die Vorgabeparameter neben einen einzustellen Durchsatz der Anlage auch Vorgaben für einen einzustellenden Energieverbrauch der Anlage umfassen. Der Energieverbrauch einer Anlage, welcher in der Vergangenheit eine eher untergeordnete Rolle spielte, nimmt zunehmend einen Großteil des Interesses bei der betriebswirtschaftlichen Planung einer Anlage ein.

Gemäß einer vorteilhaften Fortbildung des erfindungsgemäßen Verfahrens ist für die Ermittlung des Satzes von Teillastzuständen der Anlage ein dezentrales Optimierungsverfahren vorgesehen. Dieses Optimierungsverfahren erfolgt insbesondere unter Einsatz von marktbasierten Optimierungsverfahren.

Gemäß einer weiteren vorteilhaften Ausgestaltung der Erfindung ist vorgesehen, den durch Simulation erhaltenen Satz von Teillastzuständen mittels eines iterativen Optimierungsverfahrens zu überarbeiten. Dies erfolgt durch eine wiederholte Ermittlung eines Satzes von Teillastzuständen mit überarbeiteten Vorgabeparametern und/oder mit mindestens überarbeitetem Energiemodell. Bei einer solchen Überarbeitung einer Ermittlung von Teillastzuständen ist eventuell auch zu erwägen, eine vorhandene Komponente einer Anlage durch eine alternative Komponente auszutauschen, welche über ein Energiemodell verfügt, dass sich von dem der ausgetauschten Komponente unterscheidet. Das Verfahren gemäß dieser Ausführungsform kann in Bedarfsfall iterativ durchlaufen werden, um zu einem optimierten Satz von Teillastzuständen der Anlage zu gelangen.

Die erfindungsgemäße Ermittlung des Satzes von Teillastzuständen der Anlage kann alternativ zentral oder dezentral erfolgen. In einem zentralen Ansatz werden die jeweiligen Energiemodelle der Komponenten an ein zentrales System, beispielsweise an ein Prozesssteuerungssystem (Manufacturing Execution System) übermittelt, um anschließend eine zentrale Ermittlung durchzuführen. Das zentrale System kann beispielsweise Daten eines Engineeringtools verwenden.

Im Fall eines dezentralen Ansatzes ist die Auswertung auf mehrere Komponenten verteilt. Diese dezentrale Variante ist insbesondere dann vorteilhaft, wenn jede Komponente eine eigene Datenverarbeitungsmöglichkeit sowie Kommunikationseinheit besitzt.

Ein Ausführungsbeispiel mit weiteren Vorteilen und Ausgestaltungen der Erfindung wird im Folgenden anhand der Zeichnung näher erläutert. Dabei zeigen:
- Fig. 1:: ein Strukturbild zur schematischen Darstellung eines Energiemodells einer Komponente;
- Fig. 2:: ein Strukturbild zur schematischen Darstellung einer Ermittlung eines Satzes von Teillastzuständen; und;
- Fig. 3:: ein Ablaufdiagramm zur schematischen Darstellung einer weiteren Optimierung eines Satzes von Teillastzuständen.

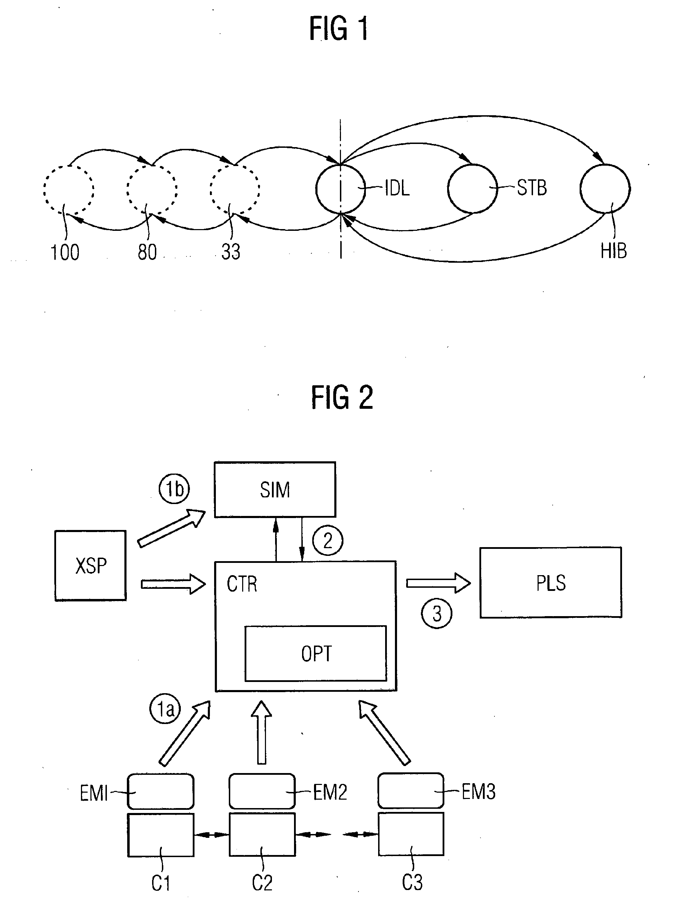

In Fig. 1 ist eine schematische Darstellung eines Energiemodells einer Komponente gezeigt. Unter Anwendung des komponentenbasierten Energiemodells ist ein Energiemanagement auf Komponentenebene durch Vorsehung von Betriebszuständen, in der Zeichnung rechts von der strichpunktierten Linie sowie durch Vorsehung von Teillastzuständen, in der Zeichnung links von der strichpunktierten Linie dargestellt, realisiert.

In der rechten Hälfte des Energiemodells ist ein erster Betriebszustand IDL oder »Idle« der Komponente dargestellt. In einem Kreis, der rechts vom ersten Betriebszustand IDL angeordnet ist, ist ein zweiter Betriebszustand STB oder »Standby« der Komponente dargestellt. Schließlich ist ein dritter Betriebszustand HIB oder »Hibernate« der Komponente dargestellt.

Jeder Betriebszustand HIB, IDL, STB im Energiemodell ist mit einer - nicht dargestellten - Parametermenge versehen. Innerhalb dieser Parametermenge können beispielsweise Zeiträume definiert werden, welche angeben, wie lange ein jeweiliger Betriebszustand mindestens bzw. maximal eingehalten werden darf sowie eine Zeitdauer, welche für einen Wechsel von einem ersten Betriebszustand in einen zweiten Betriebszustand benötigt wird.

Die in der rechten Hälfte dargestellten Betriebszustände HIB, IDL, STB modellieren unterschiedliche Ruhestände einer Komponente, welche beispielsweise aus dem Standard PROFIenergy für ein Energiemanagement einer Komponente vorgesehen sind.

Die Definition von Teillastzuständen, in der Zeichnung links von der strichpunktierten Linie dargestellt, ist in derzeitigen Lösungen dagegen nicht vorgesehen. Mit anderen Worten ist eine Aussage darüber, ob eine Komponente, geschweige denn eine Anlage, in einen Teillastzustand wechseln kann, momentan nicht zugänglich. Damit existiert gegenwärtig auch keine Möglichkeit, verschiedene Teillastzustände in Abhängigkeit von eingesetzten Komponenten sowie in Abhängigkeit von Randbedingungen wie Effizienz, Durchsatz usw. automatisiert zu bestimmen.

Gemäß der erfindungsgemäßen Lösung wird das in Fig. 1 dargestellte Energiemodell einer Komponente um die Teillastzustände 33, 80, 100 erweitert.

Ein erster Teillastzustand 33 enthält in einer zugehörigen Parametermenge neben den oben genannten Parametern auch eine Information darüber, welches Betriebsverhalten in diesem ersten Teillastzustand 33, welcher einer 33%-igen Auslastung im Verhältnis zu einer Volllast der Komponente entspricht, in der Komponente realisiert wird.

Die das besagte Betriebsverhalten darstellende Betriebsparameter umfassen insbesondere Werte wie einen Durchsatz der Komponente im ersten Teillastbetrieb 33, sowie einen Energieverbrauch in diesem Teillastzustand 33 und einen für einen Zustandswechsel erforderlichen Energieverbrauch.

Beispielsweise kann für einen Antrieb hinterlegt sein, dass im ersten Teillastzustand 33, welcher einer 33%-igen Auslastung des Antriebs entspricht, die Sollgeschwindigkeit des Antriebs 3.000 Umdrehungen pro Sekunde beträgt. Weiterhin kann in den Betriebsparametern hinterlegt sein, dass der Antrieb mit 500 s⁻² beschleunigt und abbremst.

In vorteilhaften Ausführungsformen können Angaben hinterlegt sein, welche Auswirkungen auf Wartungsintervalle, Verschleiß und Lebensdauer der entsprechenden Komponente definieren. Diese Angaben erklären sich daraus, dass ein häufiger Wechsel zwischen Teillastzuständen fallweise negative Auswirkungen auf Wartungsintervalle oder Lebenszeit der Komponente haben kann. Eine Kombination aller genannten Betriebsparameter wird im folgenden Energiemodell genannt.

In Fig. 1 ist ein zweiter Teillastzustand 80 dargestellt, welcher einer 80%-igen Auslastung der Komponente entspricht, sowie ein dritter Teillastzustand 100, welcher einer Volllast der Komponente, also 100%, entspricht.

Fig. 2 zeigt ein Strukturbild zur schematischen Darstellung einer Ermittlung von Teillastzuständen einer Anlage unter Anwendung des erfindungsgemäßen Verfahrens. Exemplarisch dargestellt sind drei Komponenten C1,C2,C3 der Anlage, wobei jeder jeweiligen Komponente C1,C2,C3 ein jeweiliges Energiemodell EM1,EM2,EM3 zugeordnet ist. Unter Zuordnung ist einerseits eine dezentrale Zuordnung zu verstehen, bei der die Energiemodelle EM1,EM2,EM3 beispielsweise in einem der Komponente zugehörigen Speicherbereich vorgehalten sind. Im Falle einer - nicht dargestellten - zentralen Zuordnung sind die Energiemodelle EM1,EM2,EM3 zentral, beispielsweise in einer Prozessdatenbank, vorgehalten.

Die Energiemodelle EM1,EM2,EM3, genauer, die in den die Energiemodellen EM1,EM2,EM3 vorgehaltenen Betriebsparameter sowie Teillastzustandsparameter werden in einem ersten Schritt la ausgewertet. Die Energiemodelle EM1,EM2,EM3 sind vorzugsweise in einer semantischen Beschreibungssprache strukturiert.

Weiterhin werden äußere Vorgaben XSP in einem zweiten Schritt 1b ausgewertet. Als äußere Vorgabe XSP ist z.B. ein Durchsatz in Höhe von 50% des Volllastbetriebs der Anlage bei minimalem Energieverbrauch zu realisieren. Wartungs- und Verschleißwerte können als äußere Vorgaben XSP definiert werden.

Die Auswertung erfolgt beispielsweise in einer von einer Steuerungseinheit CTR ausgeführten Optimierungskomponente OPT. Die vorgenannte Ausführungsform unter Verwendung einer zentralen Steuerungseinheit CTR kann bedarfsweise auch durch eine - nicht dargestellte - dezentrale Auswertung ersetzt werden, bei der die einzelnen Komponenten C1,C2,C3 in kollaborativer Weise die Auswertung vornehmen.

Auf Grundlage der Energiemodelle EM1,EM2,EM3 und der äußeren Vorgaben XSP wird nun in der Optimierungskomponente OPT ein vorläufiger Satz von Teillastzuständen der Anlage ermittelt. In diesem Optimierungsschritt ermittelt die Optimierungskomponente OPT, beispielsweise unter Anwendung eines dezentralen Optimierungsverfahrens, insbesondere auf Basis einer marktbasierten Verhandlung, einen Teillastzustand einer jeden Komponente C1,C2,C3.

Der vorläufige Satz von Teillastzuständen der Anlage wird in einem Verfahrensschritt 2 einer Simulationskomponente SIM zugeführt, in welcher eine Simulation des vorläufigen Satzes von Teillastzuständen anhand eines parametrisierbaren Simulationsmodells der Anlage durchgeführt wird. Dieser Schritt dient einer Verifikation des für die Anlage ermittelten Satzes von Teillastzuständen anhand realer Gegebenheiten der Anlage. Das Simulationsmodell der Anlage modelliert den übergeordneten Prozess der Anlage. Den für die Simulation notwendigen Datenaustausch übernimmt die Steuerkomponente CTR. Während die Optimierungskomponente OPT alle erlaubten Teillastzustände auf Basis der Energiemodelle EM1,EM2,EM3 errechnet, schränkt die Einbindung des Simulationskomponente SIM die Teillastzustände auf die Gegebenheiten der Anlage ein, wobei auch eine Ausgangssituation bzw. ein Anfangszustand der Anlage Berücksichtigung finden kann.

Dieser Verfahrensschritt 2 wird durch die in der Zeichnung dargestellten beiden Pfeile bei Bedarf mehrmals ausgeführt, wobei das bedarfsweise überarbeitete Ergebnis der Simulation an die Optimierungskomponente OPT zurückgegeben wird und das Ergebnis der Simulation eine erneute Optimierung erfährt.

Das Simulationsergebnis wird in der Optimierungskomponente OPT dabei erneut ausgewertet und eventuell die Optimierung neu gestartet, um einen überarbeiten Satz von vorläufigen Teillastzuständen zu errechnen.

Nachdem auf diese Weise mindestens ein Optimierungs- und Simulationsschritt, im Bedarfsfall in einem iterativen Prozess, durchgeführt wurde wird als Ergebnis in einem Verfahrensschritt 3 ein Satz von Teillastzuständen PLS der Anlage ausgegeben.

Der Satz von Teillastzuständen enthält die einzustellenden Teillastzustände mindestens einer Komponente C1,C2,C3 der Anlage auf Basis des über die äußeren Vorgaben XSP einzustellenden Teillastzustandes der Anlage. Beispielsweise kann sich bei einem halbierten Durchsatz der Anlage als äußere Vorgabe ein Teillastzustand der Förderbänder von 40%, ein Teillastzustand von Robotern von 60%, ein Teillastzustand des Fertigungssteuerungssystems von 90% usw. ergeben.

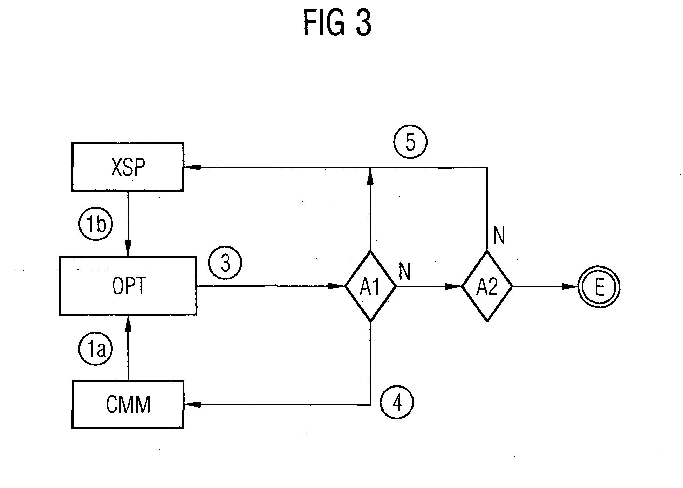

Der ermittelte Satz von Teillastzuständen PLS kann optional von einem Anlagenbetreiber oder -planer überprüft werden und erneut einer Optimierungskomponente OPT zugeführt werden Sollte die Anzahl der Teillastzustände oder deren Werte nicht umsetzbar sein, können, wie in Fig. 3 dargestellt, entweder die äußeren Vorgaben XSP, entsprechend Schritt 5, oder auch Komponenten der Anlage modifiziert oder ausgetauscht, entsprechend Schritt 4, werden. Mit einer Modifikation oder Austausch einer Komponente C1 ändert sich auch das der Komponente C1 zugeordnete Energiemodell EM1. Damit ändert sich auch eine in Fig. 3 als Gesamtmenge CMM der einzelnen Energiemodelle EM1,EM2,EM3.

In einer ersten Verzweigung A1 »Lösungsmenge leer?« des Ablaufdiagramms der Fig. 3 wird in einem Schritt 3 zunächst geprüft, ob überhaupt auf Grundlage der äußeren Vorgaben XSP, zu denen auch eine Anlagenausstattung, ein Anlagenlayout sowie eine Einsteuerung der Anlage zählt sowie der Gesamtmenge CMM der einzelnen Energiemodelle EM1,EM2,EM3 ein Satz von Teillastzuständen PLS durch die Optimierungskomponente OPT ermittelbar ist.

Ist die Lösungsmenge nicht leer, entsprechend dem mit N gekennzeichneten »Nein«-Zweig der ersten Verzweigung A1, wird in einer zweiten Verzweigung A2 »Lösung akzeptabel?« eine Überprüfung durch den Anlagenbetreiber oder -planer vorgenommen. Im gegenteiligen Fall, bei leerer Lösungsmenge, ist eine Anpassung gemäß Schritt 5 unter Änderung der äußeren Vorgaben, oder, gemäß Schritt 4, unter Anpassung der Gesamtmenge CMM der einzelnen Energiemodelle EM1,EM2,EM3, erforderlich. Im Schritt 4 konnte kein möglicher Teillastzustand eruiert werden. Als Konsequenz müssen entweder die äußeren Vorgaben oder sogar das Maschinenmodell, d.h. es müssen andere Maschinen verwendet werden, geändert werden.

In ähnlicher Weise wird im Falle eines negativen Ergebnisses, entsprechend dem mit N gekennzeichneten »Nein«-Zweig, der zweiten Verzweigung A2 »Lösung akzeptabel?« eine Anpassung gemäß Schritt 5 unter Änderung der äußeren Vorgaben vorgenommen.

Im Schritt 5 konnten Teillastzustände gefunden werden, diese sind jedoch nach dem Wissen des Anlagenbauers nicht akzeptabel. In diesem Fall können ebenfalls die äußeren Vorgaben (z.B. anderer Durchsatz) angepasst werden. Auf diese Weise kann iterativ die beste Konfiguration in Form eines optimalen Satzes von Teillastzuständen gefunden werden, gemäß Verfahrensschritt E, »Ende«.

## Patentansprüche

1. Verfahren zur Ermittlung eines Teillastzustandes (33) einer mehrere Komponenten (C1,C2,C3) umfassenden Anlage, umfassend folgende Schritte:
- Auswerten eines Energiemodells (EM1,EM2,EM3) mindestens einer Komponente der Anlage, durch welches mindestes einem Teillastzustand dieser Komponente ein Satz von Betriebsparametern dieser Komponente zugeordnet ist;
- Auswerten von Vorgabeparameter, die Vorgabeparameter umfassen Vorgaben (XSP) für einen einzustellenden Durchsatz der Anlage;
- Ermittlung eines Satzes von Teillastzuständen (33,80,100) der Anlage auf Grundlage des mindestens einen Energiemodells unter Berücksichtigung der Vorgabeparameter;
- Simulation des Satzes von Teillastzuständen anhand eines parametrisierbaren Simulationsmodells der Anlage.

2. Verfahren nach Anspruch 1,
**dadurch gekennzeichnet,**
**dass** die Betriebsparameter des Energiemodells eine Zeitdauer für einen Wechsel von und/oder in einen jeweiligen Teillastzustand der Komponente enthalten.

3. Verfahren nach einem der vorgenannten Ansprüche,
**dadurch gekennzeichnet,**
**dass** die Betriebsparameter des Energiemodells einen Energieverbrauch eines jeweiligen Teillastzustands der Komponente enthalten.

4. Verfahren nach einem der vorgenannten Ansprüche,
**dadurch gekennzeichnet,**
**dass** die Betriebsparameter des Energiemodells einen Energieverbrauch für einen Wechsel von und/oder in einen jeweiligen Teillastzustand der Komponente enthalten.

5. Verfahren nach einem der vorgenannten Ansprüche,
**dadurch gekennzeichnet,**
**dass** die Betriebsparameter des Energiemodells Angaben zum Betrieb, insbesondere zum Durchsatz, der Komponente in einem jeweiligen Teillastzustand enthalten.

6. Verfahren nach einem der vorgenannten Ansprüche,
dass die Betriebsparameter des Energiemodells Werte enthalten, welche eine Auswirkung eines Teillastzustandes und/oder eines Wechsel zwischen jeweiligen Teillastzustand auf Lebensdauer und erforderliche Wartungsintervalle der Komponente enthalten.

7. Verfahren nach einem der vorgenannten Ansprüche,
dass die Vorgabeparameter Vorgaben für einen einzustellenden Energieverbrauch der Anlage umfassen.

8. Verfahren nach einem der vorgenannten Ansprüche,
**dadurch gekennzeichnet,**
**dass** die Ermittlung des Satzes von Teillastzuständen der Anlage auf Basis einer dezentralen Optimierung, insbesondere unter Einsatz von marktbasierten Verfahren erfolgt.

9. Verfahren nach einem der vorgenannten Ansprüche,
**dadurch gekennzeichnet,**
**dass** anhand des durch Simulation erhaltenen Satzes von Teillastzuständen eine erneute Ermittlung eines Satzes von Teillastzuständen mit überarbeiteten Vorgabeparametern und/oder mit mindestens einem überarbeiteten Energiemodell erfolgt.

10. Verfahren nach Anspruch 9,
**dadurch gekennzeichnet,**
**dass** ein optimierter Teillastzustand der Anlage nach mindestens einmaligem Ausführen des Verfahrensschrittes gemäß Anspruch 9 ermittelt wird.

11. Computerprogrammprodukt mit Mitteln zur Durchführung des Verfahrens nach einem der vorhergehenden Ansprüche 1 bis 10, wenn das Computerprogrammprodukt an einem Prozesssteuerungssystem zur Ausführung gebracht wird.

12. Verwendung eines optimierten Teillastzustands der Anlage nach Anspruch 10 in einem Prozesssteuerungssystem.

13. Verwendung eines optimierten Teillastzustands der Anlage nach Anspruch 10 in einer Komponente.

## Claims

1. Method for the determination of a part-load condition (33) of a system comprising several components (C1, C2, C3), comprising the following steps:
- Evaluation of an energy model (EM1, EM2, EM3) of at least one component of the system, by means of which a set of operating parameters of this component is allocated to at least one part-load condition of this component;
- Evaluation of specification parameters, these specification parameters comprising specifications (XSP) for a throughput of the system which is to be set;
- Determination of a set of part-load conditions (33, 80, 100) of the system on the basis of the at least one energy model, taking account of the specification parameters;
- Simulation of the set of part-load conditions on the basis of a parameterisable simulation model of the system.

2. Method according to claim 1,
**characterised in that**
the operating parameters of the energy model contain a time duration for a change from and/or to a particular part-load condition of the component.

3. Method according to one of the preceding claims,
**characterised in that**
the operating parameters of the energy model contain an energy consumption of a particular part-load condition of the component.

4. Method according to one of the preceding claims,
**characterised in that**
the operating parameters of the energy model contain an energy consumption for a change from and/or to a particular part-load condition of the component.

5. Method according to one of the preceding claims,
**characterised in that**
the operating parameters of the energy model contain data regarding the operation, in particular the throughput, of the component in a particular part-load condition.

6. Method according to one of the preceding claims,
**characterised in that**
the operating parameters of the energy model contain values which contain an effect of a part-load condition, and/or of a change between particular part-load states, on the service life and required maintenance interval of the component.

7. Method according to one of the preceding claims,
**characterised in that**
the specification parameters comprise specifications for an energy consumption of the system which is to be set.

8. Method according to one of the preceding claims,
**characterised in that**
the determination of the set of part-load conditions of the system takes place on the basis of a decentralised optimisation, in particular with the use of market-based methods.

9. Method according to one of the preceding claims,
**characterised in that**
on the basis of the set of part-load conditions obtained by simulation, a new determination of a set of part-load conditions is carried out, with revised specification parameters and/or with at least one revised energy model.

10. Method according to claim 9,
**characterised in that**
an optimised part-load condition of the system is determined after at least one execution of the method step according to claim 9.

11. Computer program product with means for carrying out the method according to one of the preceding claims 1 to 10, when the computer program is located on a process control system for execution.

12. Use of an optimised part-load condition of the system according to claim 10 in a process control system.

13. Use of an optimised part-load condition of the system according to claim 10 in a component.

## Revendications

1. Procédé de détermination d'un état de charge partielle (33) d'une installation comprenant plusieurs composants (C1, C2, C3), comprenant les étapes suivantes :
- évaluation d'un modèle énergétique (EM1, EM2, EM3) d'au moins un composant de l'installation, par le biais duquel un ensemble de paramètres de fonctionnement de ce composant est associé à au moins un état de charge partielle de ce composant ;
- évaluation de paramètres par défaut, les paramètres par défaut comprennent des valeurs de référence (XSP) pour un débit de l'installation à régler ;
- détermination d'un ensemble d'états de charge partielle (33, 80, 100) de l'installation sur la base de l'au moins un modèle énergétique en tenant compte des paramètres par défaut ;
- simulation de l'ensemble d'états de charge partielle en utilisant un modèle de simulation de l'installation paramétrable.

2. Procédé selon la revendication 1, **caractérisé en ce que** les paramètres de fonctionnement du modèle énergétique comprennent une durée nécessaire à un changement d'état de charge partielle respectif et/ou à une modification d'un état de charge partielle respectif du composant.

3. Procédé selon l'une des revendications précédentes, **caractérisé en ce que** les paramètres de fonctionnement du modèle énergétique comprennent une consommation d'énergie d'un état de charge partielle respectif du composant.

4. Procédé selon l'une des revendications précédentes, **caractérisé en ce que** les paramètres de fonctionnement du modèle énergétique comprennent une consommation d'énergie nécessaire à un changement d'état de charge partielle respectif et/ou à une modification d'un état de charge partielle respectif du composant.

5. Procédé selon l'une des revendications précédentes, **caractérisé en ce que** les paramètres de fonctionnement du modèle énergétique comprennent des données relatives au fonctionnement, notamment au débit, du composant dans un état de charge partielle respectif.

6. Procédé selon l'une des revendications précédentes, **caractérisé en ce que** les paramètres de fonctionnement du modèle énergétique comprennent des valeurs parmi lesquels un effet d'un état de charge partielle et/ou d'un changement entre états de charge partielle respectifs sur la durée de vie du composant et les intervalles de maintenance nécessaires pour ce composant.

7. Procédé selon l'une des revendications précédentes, **caractérisé en ce que** les paramètres par défaut comprennent des valeurs de référence pour une consommation d'énergie de l'installation à régler.

8. Procédé selon l'une des revendications précédentes, **caractérisé en ce que** la détermination de l'ensemble d'états de charge partielle de l'installation s'effectue sur la base d'une optimisation décentralisée, notamment en utilisant une méthode basée sur le marché.

9. Procédé selon l'une des revendications précédentes, **caractérisé en ce que**, sur la base de l'ensemble d'états de charge partielle obtenu par simulation, on procède à une nouvelle détermination d'un ensemble d'états de charge partielle avec des paramètres par défaut révisés et/ou avec au moins un modèle énergétique révisé.

10. Procédé selon la revendication 9, **caractérisé en ce qu'**un état de charge partielle optimisé de l'installation est déterminé après avoir exécuté au moins une fois l'étape de procédé selon la revendication 9.

11. Produit de programme d'ordinateur comprenant des moyens pour exécuter le procédé selon l'une des revendications précédentes 1 à 10 lorsque l'exécution du produit de programme d'ordinateur est lancée sur un système de commande de processus.

12. Utilisation d'un état de charge partielle optimisé de l'installation selon la revendication 10 dans un système de commande de processus.

13. Utilisation d'un état de charge partielle optimisé de l'installation selon la revendication 10 dans un composant.
